# EUROPEAN PATENT APPLICATION

(11) **EP 0 822 658 A1**
(43) Date of publication of application: **04.02.1998**
(21) Application number: 97890147.8
(22) Date of filing: 25.07.1997
(51) Int. Cl.: H03H 7/01, H01F 27/40

(54) **Inductor assembly and method of making same**

(30) Priority: 28.07.1996 US 688564
(71) Applicant: Bel-Fuse, Inc., Jersey City, New Jersey 07302 (US)
(72) Inventor: Kan, Wong Chiu, Taikoo Shing, Hong Kong (CN)
(74) Representative: Kopecky, Helmut, Dipl.-Ing. Kopecky & Schwarz Patentanwälte

(57) **Abstract**

A filter which includes a bobbin having a plurality of capacitors attached thereto at respective spaced locations, each capacitor having first and second electrodes. A first group of coils is wound about the bobbin between respective ones of the capacitors. A second group of coils is wound about the bobbin between respective ones of the capacitors and over respective coils of the coils of the first group. Each of the coils of the first group is connected to adjacent first electrodes of the capacitors and each of the coils of the second group is connected to adjacent second electrodes of the capacitors.

## Description

### BACKGROUND OF THE INVENTION

This invention relates to inductor assemblies and, in particular, to assemblies of inductors and other electrical components, such as filters, and to a method of making the same.

Conventional inductor/capacitor filters, such as Butterworth filters include a bobbin having a plurality of coils wound thereon which are connected to a bank of separately mounted capacitors. Typically, two bobbins, provided with wound coils, are mounted on opposite sides of a bank of capacitors. The coils of each bobbin are connected to capacitor electrodes on the same side as the coil.

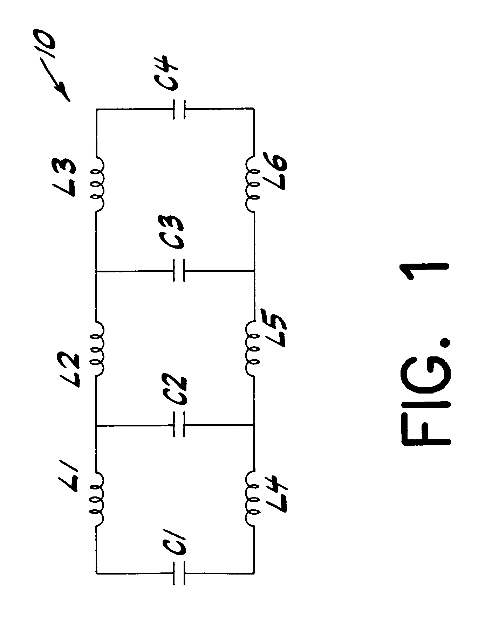

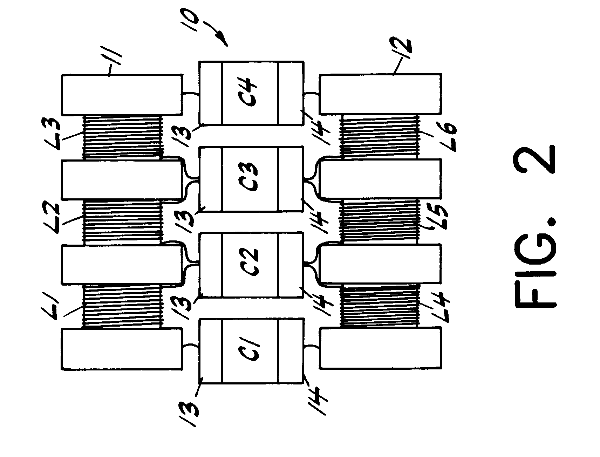

More specifically, referring to Fig. 1, there is illustrated an electrical schematic of a conventional Butterworth filter 10 which includes a bank of capacitors, C₁-C₄, interconnected with a plurality of coils L₁-L₆. Physically, referring to Fig. 2, the coils L₁-L₆ are wound on first and second bobbins 11, 12 which are arranged on opposite sides of the bank of capacitors C₁-C₄. More specifically, the coils L₁, L₂ and L₃ are wound between respective flanges of the bobbin 11 and the coils L₄, L₅ and L₆ are wound between respective flanges of the bobbin 12. The respective ends of the coils L₁, L₂ and L₃ are connected to respective first electrodes 13 of the capacitors C₁-C₄ on the side facing the coils L₁, L₂ and L₃ and the respective ends of the coils L₄, L₅ and L₆ are connected to respective second electrodes 14 of the capacitors facing the coils L₄, L₅ and L₆.

One of the problems associated with the prior art filter is the necessity of using two bobbins.

Further, prior art bobbins employ flanges to provide predetermined spacing between the inductors so as to facilitate the winding process and to maintain the winding pitch between each inductor. Flanged bobbins, however, are more costly and space consuming than unflanged bobbins.

Additionally, in conventional assembly of the prior art filter, the coils are not connected to the capacitors until after the capacitors are mounted to a printed circuit board. As a result, testing of the filter cannot be done until after the capacitors and coils have been assembled on the printed wiring board and interconnected. Accordingly, testing of the filter is more complicated than if the filter could be tested prior to assembly on the board. Further, any defects in the filter require costly and time consuming repair procedures.

### SUMMARY OF THE INVENTION

It is, therefore, an object of the present invention to provide an inductor assembly and method of making the same which overcomes the foregoing problems and, in particular, an inductor/capacitor assembly, such as a filter, which utilizes a single bobbin and which provides a filter assembly which can be separately tested.

It is a further object to provide an inductor assembly in which the pitch of the coils forming the inductor part of the assembly may be facilitated without the use of a flanged bobbin.

In accordance with the present invention, these and other objects are accomplished by an inductor assembly which includes a plurality of electrical components attached to a flangeless bobbin at spaced locations. Respective coils are wound about the bobbin between adjacent ones of the plurality of electrical components, the spacing between adjacent electrical components determining the pitch of the coils wound therebetween.

In accordance with an aspect of the present invention the inductor assembly includes a plurality of electrical components attached to a bobbin at spaced locations and first and second groups of coils. Each of the first group of coils is wound about the bobbin between adjacent ones of the plurality of electrical components, while each of the second group of coils is wound about the bobbin between adjacent ones of the plurality of electrical components and over the coils of the first group. The spacing between adjacent electrical components determines the pitch of the coils wound therebetween. The electrical components and the coils of the first and second groups are electrically interconnected.

In accordance with another aspect of the invention, the inductor/capacitor assembly is a filter which includes a plurality of capacitors attached to a bobbin at respective spaced locations and first and second groups of coils. Each of the coils of the first and second groups is wound about the bobbin between respective ones of the capacitors, with each coil in the second group being wound about each of the first coils. Each of the coils of the first group is connected to adjacent first electrodes of the capacitors and each of the coils of the second group is connected to adjacent second electrodes of the capacitors.

In accordance with the inventive method, the coils are formed by winding a first wire about the bobbin such that sections of the wire are wound between adjacent capacitors to form respective coils and such that sections of the first wire overlie respective first electrodes of the capacitors. A second wire is wound about the bobbin such that sections of the second wire are wound between adjacent capacitors and over the sections of the first wire and such that sections of the second wire overlie respective second electrodes of the capacitors. Then, the sections of the first wire which overlie the first electrodes of the capacitors are attached to the first electrodes and the sections of the second wire which overlie the second electrodes are attached to the second electrodes.

Other aspects and advantages of the invention will become apparent from the following more detailed description, taken in conjunction with the accompanying drawings.

### BRIEF DESCRIPTION OF THE DRAWINGS

Fig. 1 is an electrical schematic of a conventional Butterworth filter.

Fig. 2 is a plan view of a prior art assembly of the filter of Fig. 1.

Fig. 3 is a perspective view of an embodiment of a filter in accordance with the present invention having first and second groups of coils and a plurality of capacitors mounted on a single bobbin.

Fig. 4 shows the filter of Fig. 3 prior to winding of the second group of coils on the bobbin thereof.

Fig. 5 shows the filter of Fig. 3 after the second group of coils has been wound on the bobbin thereof with the first group of coils not shown for the sake of clarity.

Fig. 6 shows another embodiment of the invention employing leaded capacitors.

### DETAILED DESCRIPTION OF THE PREFERRED EMBODIMENT(S)

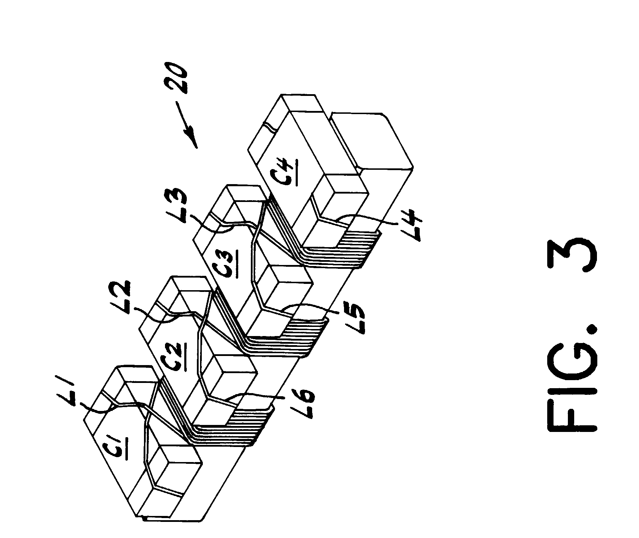

Referring now to the drawings and, in particular to Fig. 3, there as shown an inductor/capacitor assembly, such as a filter 20, illustrating certain principles of the present invention, which includes a bobbin 21. Typically, the bobbin 21 is rectangular in cross-sectional shape but other cross-sectional shapes may also be suitably employed. In addition, the bobbin 21 is typically made of a magnetic material, such as a combination of powdered iron and plastic.

A plurality of flat capacitors, C₁, C₂, C₃ and C₄, such as multilayer chip capacitors in surface mount or leaded form, is mounted to the bobbin 21 at spaced locations by any suitable attachment method, such as cement or ultraviolet cured epoxy. First and second groups of coils L₁, L₂ and L₃ and L₄, L₅ and L₆, respectively, are wound about the bobbin 21 between respective ones of the capacitors C₁-C₄, with the second group of coils L₄, L₅ and L₆ being wound about the bobbin over the first group L₁, L₂ and L₃. Although the coils L₁-L₆ may be wound as discreet entities, with the respective ends of the coils then connected to respective electrodes of the capacitors, preferably the coils L₁-L₆ are wound continuously.

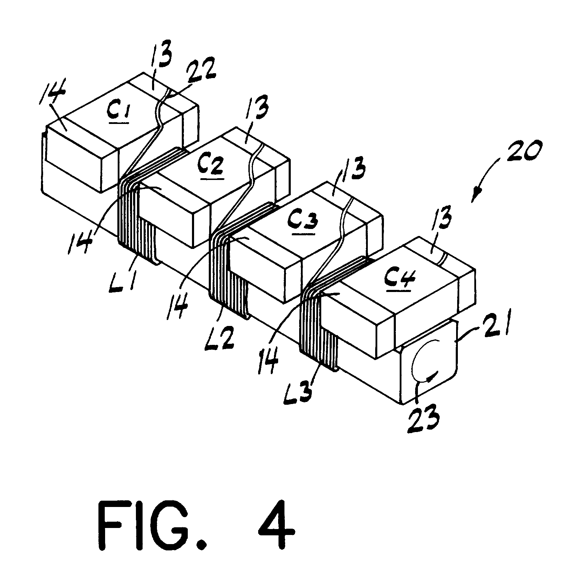

More specifically, referring to Fig. 4, the coils L₁-L₃ of the first group are formed by first attaching one end of a wire 22 to the first electrode 13 of the first capacitor C₁. The wire 22 is then passed across this electrode and wound about the bobbin 21 between the capacitors C₁ and C₂ to form the coil L₁. The wire 22 is then wound between the capacitors C₂ and C₃ and then between the capacitors C₃ and C₄ to form the coils L₂ and L₃, respectively. The sections of wire between respective coils are then physically connected to the underlying capacitor electrodes 13 by any suitable process, such as soldering.

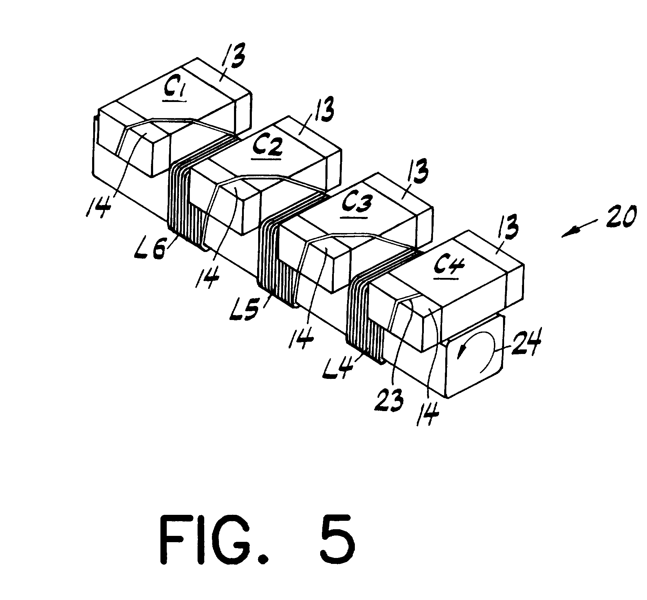

Referring now to Fig. 5, similarly to the forming of the first group of coils L₁, L₂ and L₃, the coils L₄, L₅ and L₆ of the second group are formed by winding a wire about the bobbin continuously with the sections between the coils L₄, L₅ and L₆ passing over respective capacitor second electrodes 14. Thereafter, the sections between the coils L₄, L₅ and L₆ of the second group are attached to the underlying respective second electrodes 14 of the capacitors by any suitable process, such as soldering.

The second group of coils L₄, L₅ and L₆ are wound by winding backward from the end of the first winding to the start of the winding without changing the turning or winding direction. This results in a desirable reversal of polarity for the second coils. If reversal of polarity is not desired, then the winding direction for the second coils is made opposite to that for the first coils. The spacing between the capacitors C₁, C₂, C₃ and C₄ facilitates maintenance of the winding pitch thereby enabling use of a flangeless bobbin.

Because the coils L₁-L₆ and capacitors C₁-C₄ are electrically interconnected, the assembly may be tested prior to its being mounted to a printed wiring board.

From an electrical schematic standpoint, the filter 20 and the prior art filter 10 of Fig. 1 would appear to be electrically identical. That is, schematically the filter 20 would be represented by the same schematic shown in Fig. 1 for the filter 10. From an electrical performance standpoint, however, the filter 20 exhibits significantly improved performance over the filter 10. More specifically, due to the extremely short interconnect between the inductor ends and the capacitors, there is substantial improvement in insertion loss and a reduction in unwanted leakage as compared to the prior art filter 11. Also, by sharing a common core, coupling and matching of the coils is improved, thereby improving differential to common and common to common rejection.

Although there are advantages, such as reduced cost and space savings, to using flangeless bobbins, a flanged bobbin in which the capacitors are mounted to the flanges and the coils wound between the flanges may also be employed. Additionally, although the exemplary embodiment of Figs. 3 and 5 shows six coils interconnected with four capacitors, the invention is not so limited and may be used advantageously in any arrangement in which at least two coils and two capacitors need to be interconnected.

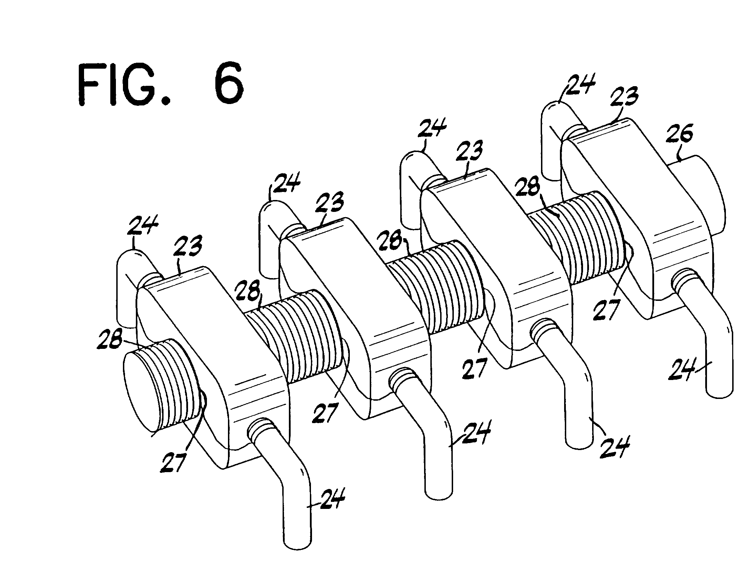

Turning now to Figure 6, there is shown another embodiment of the invention which employs leaded tubular capacitors 23 rather than the flat capacitors C₁-C₄ of Figures 3-5. In this embodiment, the capacitors 23, each of which has respective leads 24, are attached to a bobbin 26. Although the bobbin may have any suitable shape, in the embodiment of Fig. 6 it is shown as cylindrical. Further, although the capacitors 23 may be attached directly to the outer surface of the bobbin 26, the bobbin 26 advantageously has a plurality of recesses 27 and the capacitors 23 are received into respective ones of the recesses and therein attached to the bobbin 26. Respective first and second groups of coils 28 are then wound between the capacitors 23, the spacing between capacitors 23 determining the pitch of the coils 28. During the winding process, after winding of an individual coil 28, the wire is wrapped around the lead 24 of the adjacent capacitor 23. Then, the next coil 28 is wound and the lead 24 of the next adjacent capacitor 23 wrapped. The winding proceeds until all of the coils 28 have been wound and connected to respective leads 24, with the coils 28 of the second group wound over the coils of the first group. After winding, the leads may be soldered by, for example, dip soldering and the soldered leads inserted into and soldered to through holes in a printed wiring board. Advantageously, the assembly is tested prior to soldering the leads to the printed wiring board.

The winding for both the embodiment of Fig. 3-5 and that of Fig. 6 may be effected by any suitable winding method and machine. Examples of suitable machines are multispindle winding machines, such as the WM2001/4-200, WM2001/6-100 and WM2002/6-100 available from Marsilli & Co. spa, Castelleone, Italy.

Although the present invention has been described in relation to particular embodiments thereof, many other variations and modifications and other uses will become apparent to those skilled in the art. For example, although the invention has been described in connection with a Butterworth filter, as should be apparent, its use is not so limited and the invention may be used in connection with other filters and other inductor assemblies, such as delay lines. Also, although the invention has been described in connection with assemblies of inductors and capacitors, it may be used in connection with assemblies of inductors and any other electrical components, such as resistors. It is preferred, therefore, that the present invention not be limited by the specific disclosure herein, but only by the appended claims.

## Claims

1. An inductor assembly, which comprises:
a flangeless bobbin;
a plurality of electrical components attached to the bobbin at spaced locations; and
respective coils wound about the bobbin between adjacent ones of the plurality of electrical components, the spacing between adjacent electrical components determining the pitch of the coil wound therebetween.

2. An inductor assembly, which comprises:
a bobbin;
a plurality of electrical components attached to the bobbin at spaced locations;
a first group of coils, each of the coils of the first group being wound about the bobbin between adjacent ones of the plurality of electrical components;
a second group of coils, each of the coils of the second group being wound about the bobbin between adjacent ones of the plurality of electrical components and over the coils of the first group; and wherein
the spacing between adjacent electrical components determining the pitch of the coils wound therebetween and the electrical components and the coils of the first and second groups are electrically interconnected.

3. An assembly according to claim 2, wherein the bobbin is flangeless.

4. An assembly according to claim 2, wherein the bobbin has a plurality of spaced flanges equal in number to the number of electrical components, each of the electrical components being attached to the bobbin by being attached to a respective one of the flanges.

5. An assembly according to claim 2, wherein the bobbin has a plurality of spaced recesses equal in number to the number of electrical components, each of the electrical components being attached to the bobbin by being received in a respective one of the recesses.

6. A filter, comprising:
a bobbin;
a plurality of capacitors attached to the bobbin at respective spaced locations, each capacitor having first and second electrodes;
first and second groups of coils, each coil of the first group being wound about the bobbin between respective ones of the capacitors and each of the coils of second group being wound between respective ones of the capacitors and over the opposite respective coils of first group, the spacing between adjacent capacitors determining the pitch of the coils wound therebetween; and
each of the coils of the first group being connected to adjacent first electrodes of the capacitors and each of the coils of the second group being connected to adjacent second electrodes of the capacitors.

7. A filter according to claim 2, wherein each coil of the first group of coils has first and second ends which are connected to the first electrodes of adjacent capacitors and each end of the second group of coils has first and second ends which are connected to the second electrodes of adjacent capacitors.

8. A filter according to claim 3, wherein the bobbin has at least one flat surface and the capacitors are attached to the flat surface.

9. A filter according to claim 4, wherein each of the capacitors has at least one flat surface and such flat surface is attached to the flat surface of the bobbin.

10. A method of assembling a filter comprising the steps of:
providing a bobbin;
attaching a plurality of capacitors to the bobbin at spaced locations thereof, each of the capacitors having respective first and second electrodes;
winding a first wire about the bobbin such that sections of the wire are wound between adjacent capacitors to form respective coils and such that sections of the first wire overlie respective first electrodes of the capacitors;
winding a second wire about the bobbin wire such that sections of the second wire are wound between adjacent capacitors and over the sections of the first wire and such that sections of the second wire overlie respective second electrodes of the capacitors; and
attaching the sections of the first wire which overlie the first electrodes of the capacitors to the first electrodes and attaching the sections of the second wire which overlie the second electrodes to the second electrodes.
